Europäisches Patentamt

European Patent Office

Office européen des brevets

(11) Publication number: **0 303 485**
A2

## (12) EUROPEAN PATENT APPLICATION

(21) Application number: 88307441.1

(22) Date of filing: 11.08.88

(51) Int. Cl.⁴: **H 05 K 3/32**
H 05 K 1/00, H 05 K 3/40
// H05K3/46

(30) Priority: 12.08.87 GB 8719076

(43) Date of publication of application:
15.02.89 Bulletin 89/07

(84) Designated Contracting States:
AT BE CH DE ES FR GB GR IT LI NL SE

(71) Applicant: BICC Public Limited Company
Devonshire House Mayfair Place
London W1X 5FH (GB)

(72) Inventor: Lawrence, Howard
49, Evelyn Crescent
Shirley Southampton, SO1 5JS (GB)

(74) Representative: Ross Gower, Edward Lewis et al
BICC Group Patents & Licensing Department Network
House 1 Ariel Way
London W12 7SL (GB)

(54) An improved circuit board.

㊖ A circuit board in which the patterns of electrically conductive strips and/or pads can be of either standard or non-standard form and which can be designed and assembled by a user comprises a rigid electrically insulating board 1 having a multiplicity of holes 2 through the board arranged in a pattern of rows and columns and, secured to one major surface of the board, a separately formed flexible sheet 4 of electrically insulating material carrying on the surface of the sheet remote from the board a pattern of electrically conductive strips and/or pads 8 which overlies holes in the board. The strips and/or pads 8 are of such an electrically conductive material and of such a thickness that, when a pin C is urged through an electrically conductive strip or pad and the underlying flexible sheet 4 into an underlying hole 2 in the board, electrically conductive material pierced by the pin will effect an electrical contact with the pin passing through the material.

Fig.1.

EP 0 303 485 A2

**Description**

## AN IMPROVED CIRCUIT BOARD

This invention relates to circuit boards of the kind comprising a substantially rigid board of which at least the major surfaces are of electrically insulating material, which carries on one or each of its major surfaces a pattern of strips and/or pads of metal or metal alloy of high electrical conductivity, usually but not necessarily copper, and which has, extending through the board and the overlying electrically conductive metal strips and/or pads, a multiplicity of mutually spaced holes. Circuit boards of this kind will hereinafter, for convenience, be referred to as "circuit boards of the kind described".

It is the general practice for a manufacturer of circuit boards to provide circuit boards of the kind described having any one of a plurality of standard patterns of electrically conductive strips and/or pads on one or each of its major surfaces and for a user of a circuit board to modify the or each pattern on a board as required by removal of appropriate portions of the electrically conductive strips and/or by removal of appropriate electrically conductive pads. Circuit boards of the kind described having standard patterns of electrically conductive strips and/or pads are especially suitable for use in the manufacture of prototype circuits. If none of the standard patterns of electrically conductive strips and/or pads available on circuit boards of the kind described can be conveniently modified by removal of appropriate portions of the strips and/or removal of appropriate pads, a user has to arrange for a manufacturer to provide a circuit board of the kind described with a non-standard pattern of electrically conductive strips and/or pads on one or each of its major surfaces. Manufacture of such non-standard items is unpopular with manufacturers because it necessitates a change in manufacturing procedure and is unpopular with users because there is inevitably a delay in obtaining circuit boards of the kind described having non-standard patterns of electrically conductive strips and/or pads and because such circuit boards are expensive.

It is an object of the present invention to provide an improved circuit board of the kind described which is of such a construction that patterns of electrically conductive strips and/or pads of either standard or non-standard forms can be readily provided and which is especially, but not exclusively, suitable for design and assembly by a user.

According to the invention, the improved circuit board comprises a substantially rigid board of which at least the major surfaces are of electrically insulating material and which has extending through the rigid board a multiplicity of holes arranged in a pattern of rows and columns and, secured to one major surface of the rigid board, a separately formed flexible sheet of electrically insulating material which carries on the surface of the flexible sheet remote from the rigid board a pattern of electrically conductive strips and/or pads which overlies holes in the rigid board, the strips and/or pads being of such an electrically conductive material and of such a thickness that, when a pin is urged through an electrically conductive strip or pad and the underlying flexible sheet into an underlying hole in the rigid board, electrically conductive material pierced by the pin will effect an electrical contact with the pin passing therethrough.

One major surface of the rigid board may have secured thereto a laminate of two or more flexible sheets of electrically insulating material, each of which flexible sheets - except the flexible sheet immediately adjacent and secured to the rigid board - is secured to the underlying flexible sheet and each of which flexible sheets carries on the surface of the flexible sheet remote from the rigid board a pattern of electrically conductive strips and/or pads which overlie holes in the rigid board.

Where a single flexible sheet or a laminate of two or more flexible sheets is secured to one major surface of the rigid board with the pattern of electrically conductive strips and/or pads carried on the surface of the or each sheet remote from the board, a single flexible sheet or a laminate of two or more flexible sheets may be secured to the other major surface of the rigid board with a pattern of electrically conductive strips and/or pads of the or each said sheet carried on the surface of the sheet nearer the board. In this case, the or each pin will be urged into the circuit board in such a direction that it initially pierces an electrically conductive strip or pad of each flexible sheet before piercing the sheet itself.

The flexible sheet is secured to said major surface of the rigid board - and in a laminate of two or more flexible sheets a flexible sheet is secured to an underlying flexible sheet - preferably by means of double-sided self-adhesive tape of electrically insulating material in which the adhesive is a non-setting adhesive. The flexibility in shear loading offered by such non-setting adhesive accommodates any differences in the coefficients of thermal expansion of the rigid board and of surface mounted components and other components mounted on the board and electrically connected to electrically conductive strips or pads. The double-sided self-adhesive tape is preferably made of a plastics material such as polypropylene.

In one alternative arrangement, the flexible sheet may be secured to said major surface of the rigid board - and in a laminate of two or more flexible sheets a flexible sheet may be secured to an underlying flexible sheet - by means of a sheet of thermosetting adhesive material, e.g. a sheet of thermosetting acrylic-based adhesive material.

The or each separately formed flexible sheet may be made of any suitable electrically insulating plastics material but, preferably, the or each flexible sheet is made of an electrically insulating plastics material having such inherent elasticity that, when the flexible sheet is pierced by a pin, the inherent elasticity of the plastics material tends to urge the electrically conductive material of the pierced strip or pad into electrical contact with the pin. Preferably, also, the electrically insulating plastics material of the or each flexible sheet is transparent or translucent. Preferred electrically insulating plastics materials having appropriate inherent elasticity include polyimides, e.g. that sold under the registered trade mark "Kapton", and polyesters. By virtue of making the or each flexible sheet of an electrically insulating material having appropriate inherent elasticity, we have found that a contact pin can be removed and replaced a plurality of times without any unacceptable deterioration of the electrical contact between the pin and the electrically conductive material of the pierced strip or pad.

The rigid board may be made wholly of any suitable electrically insulating material, preferred materials being resin bonded glass fibre, synthetic resin bonded paper and ceramics, or the rigid board may be made of a sheet of metal or metal alloy coated with electrically insulating material, e.g. an electrically insulating plastics material. In the latter case, preferably the part of the metal sheet bounding each hole in the sheet is also coated with an electrically insulating plastics material.

The improved circuit board of the present invention is suitable for use with all forms of contact pins currently available and in general use with circuit boards of the kind described; such pins may be made of phosphor-bronze and coated with tin/lead or similar electrically conductive material for reducing contact resistance between a pin and the electrically conductive material of a strip or pad. A special punching pin or pins may be used initially to form a hole or holes in an electrically conductive strip and/or pad or in electrically conductive strips or pads, the punching pin being removed prior to insertion of the appropriate contact pin or pins.

We have found that the contact pins will effect satisfactory electrical connection between electrically conductive strips and/or pads of two or more flexible sheets of a laminate secured to a major surface or of laminates secured to both major surfaces of the rigid board.

In all cases, where an electrical connection between a contact pin and an electrically conductive strip or pad is to be permanent, a permanent electrical connection may be effected by soldering the contact pin to the pierced electrically conductive strip or pad.

Where at least one flexible sheet of electrically insulating material, which carries on the surface of the flexible sheet remote from the rigid board a pattern of electrically conductive strips and/or pads, is secured to each major surface of the rigid board with the strips and/or pads overlying holes in the board, during the piercing operation a substantially rigid backing board having extending through the board a multiplicity of holes arranged in a pattern of rows and columns corresponding to the pattern of holes in the rigid board may be temporarily positioned on the side of the rigid board remote from that into which a pin or pins is or are to be urged so that the parts of a pin protruding from the circuit board will be temporarily located in a hole in the backing board, the backing board being removed after completion of the piercing operation. However, in place of the rigid backing board it is preferred to employ a block of cellular plastics material having a pair of opposed major surfaces lying in substantially parallel planes so that, when the circuit board is placed on top of the block of cellular plastics material and a pin is urged through an electrically conductive strip or pad and the underlying flexible sheet into an underlying hole in the rigid board, the part of the pin protruding from the rigid board will temporarily pierce the block of cellular plastics material. In this case, no care is necessary with regard to positioning the rigid board on the block of cellular plastics material and the cellular plastics material is substantially less expensive than the rigid backing board with the array of columns and rows of holes.

Preferably, each electrically conductive strip or pad on one surface of the or each flexible sheet comprises a coating of copper or other metal or metal alloy of high electrical conductivity. Before a flexible sheet is secured to the rigid board, the required pattern of electrically conductive strips and/or pads may be formed on said flexible sheet by coating one of its surfaces with copper and forming the required pattern by the conventional photo-engraving technique currently employed to form a pattern of copper strips and/or pads during manufacture of a circuit board of the kind described. Preferably, however, the required pattern of electrically conductive strips and/or pads is formed on a surface of a flexible sheet, before the flexible sheet is secured to the rigid board, either by printing the required pattern of strips and/or pads directly on to a copper coating on said flexible sheet with an etch-resistant ink, etching away the exposed copper, and removing the etch-resistant ink with an appropriate solvent to leave, on the surface of the flexible sheet, the required pattern of copper strips and/or pads of appropriate thickness, or by printing the required pattern of electrically conductive strips and/or pads directly on to a surface of the electrically insulating flexible sheet using an electrically conductive ink and then coating or plating the electrically conductive ink to the required thickness with a metal or metal alloy of high electrical conductivity, e.g. nickel or copper.

Printing of the required pattern of strips and/or pads either with an etch-resistant ink or with an electrically conductive ink can be readily effected using a computer aided design plotter (CAD). This is especially advantageous when a non-standard pattern of electrically conductive strips and/or pads is required.

Furthermore. since the or each flexible sheet of electrically insulating material is separately formed with respect to the rigid board and a required pattern of strips and/or pads can be printed on the or each flexible sheet with either an etch-resistant ink or an electrically conductive ink using a computer aided design plotter (CAD), a flexible sheet or flexible sheets of electrically insulating material carrying the required pattern or patterns of electrically conductive strips and/or pads can be readily formed and an improved circuit board readily assembled by a user rather than by a manufacturer. Thus, a user can readily form and assembly an improved circuit board as hereinbefore described with either a standard or non-standard pattern of electrically conductive strips and/or pads on the or each flexible sheet.

Accordingly, the present invention also includes a kit of parts for use in the assembly of an improved circuit board as hereinbefore described, which kit of parts comprises at least one substantially rigid board of which at least the major surfaces are of electrically insulating material and which has extending through the rigid board a multiplicity of holes arranged in a pattern of rows and columns; at least one separately formed flexible sheet of electrically insulating material; and means for securing a flexible sheet to a surface of the rigid board or to an underlying flexible sheet.

The kit of parts preferably also includes any one or more of pin-insertion equipment, at least one punching pin, a block of cellular plastics material having a pair of opposed major surfaces lying n substantially parallel planes or at least one substantially rigid backing board having extending through the board a multiplicity of holes arranged in a pattern of rows and columns corresponding to the pattern of holes in the or each rigid board of the kit of parts, and a plurality of at least one kind of contact pin.

Preferably, the or each separately formed flexible sheet of the kit of parts has a coating of copper or other metal or metal alloy of high electrical conductivity on one surface of the sheet, the coating being of such a thickness that, when a pattern of strips and/or pads has been formed from the coating on the sheet and the sheet is secured to a surface of the rigid board in such a way that the pattern of strips and/or pads overlies holes in the rigid board and a pin is urged through a strip or pad into an underlying hole in the rigid board, copper or other electrically conductive metal pierced by the pin will effect an electrical contact with the pin passing therethrough. Where the kit of parts includes one or more than one separately formed copper coated flexible sheet of electrically insulating material, preferably the kit of parts also includes any one or more of etch-resistant ink, solvent, thinners and cleaners to suit the pen or an applicator of a computer aided design plotter (CAD).

Where the kit of parts includes one or more than one flexible sheet of electrically insulating material which does not have a coating of copper or other metal or metal alloy of high electrical conductivity on one of its surfaces, the kit of parts may also include electrically conductive ink, thinners and cleaners to suit the pen or an applicator of a computer aided design plotter (CAD).

The present invention further includes, for use in the assembly of an improved circuit board as hereinbefore described, a flexible sheet of electrically insulating material which carries on one of its surfaces a pattern of electrically conductive strips and/or pads which strips and/or pads are of such an electrically conductive material and are of such a thickness that, when the flexible sheet is secured to a surface of a substantially rigid board of which at least the major surfaces are of electrically insulating material and which has extending through the rigid board a multiplicity of holes arranged in a pattern of rows and columns in such a way that the pattern of electrically conductive strips and/or pads is remote from and overlies holes in the rigid board and a pin is urged through an electrically conductive strip or pad into an underlying hole in the rigid board, electrically conductive material pierced by the pin will effect an electrical contact with the pin passing therethrough.

The invention is further illustrated by a description, by way of example, of two preferred forms of the improved circuit board with reference to the accompanying drawings, in which:-

Figure 1 is a fragmental sectional side view of a first preferred form of the improved circuit board having a single flexible sheet secured to one surface of a rigid board of electrically insulating material, and

Figure 2 is a sectional side view of a second preferred form of improved circuit board in which a single flexible sheet is secured to one surface of a rigid board of electrically insulating material and a laminate of flexible sheets is secured to the other surface of the rigid board.

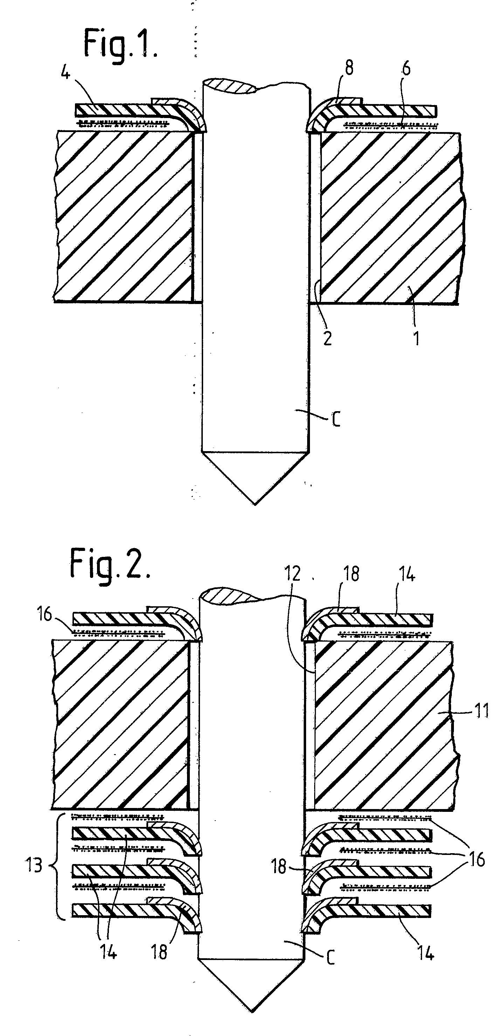

Referring to Figure 1, the first preferred form of circuit board comprises a rigid board 1 of resin bonded glass fibre having extending through the board a multiplicity of holes 2, of which one only is shown, arranged in a pattern of rows and columns. A flexible sheet 4 of a polyimide, separately formed with respect to the rigid board 1, is secured to one major surface of the rigid board by means of intervening double-sided self-adhesive tape 6 of polypropylene in which the adhesive is a non-setting adhesive. The flexible sheet 4 carries on its surface remote from the rigid board 1 a pattern of strips and/or pads 8, of which one only is shown, each consisting of a coating of copper; the strips and/or pads 8 overlie holes 2 in the rigid board.

When the circuit board is in use and it is desired, for example, to effect electrical connection between a surface mounted component and a selected copper strip or pad 8, the or each contact pin C of the component is urged through the strip or pad and the underlying flexible sheet 4 into the underlying hole 2 in the rigid board 1, the copper coating of the strip or pad being of such a thickness that copper pierced by the pin will effect electrical contact with the pin passing therethrough. The polyimide of the flexible sheet 4 has such inherent elasticity that, when the flexible sheet is pierced by the contact pin C, the inherent elasticity of the polyimide material tends to urge the copper of the pierced strip or pad into electrical contact with the pin. Furthermore, the flexibility in shear loading offered by the non-setting adhesive of the double-sided self-adhesive tape 6 will accommodate any differences in the coefficients of thermal expansion of the rigid board 1 and the surface mounted components and other components to be mounted on the board.

Alternatively, prior to insertion of the or each contact pin of the surface mounted component, the or each selected copper strip or pad 8 and the underlying flexible sheet 4 may be initially pierced by means of a special punching pin which is removed prior to insertion of the or a contact pin of the surface mounted component.

The second preferred form of circuit board shown in Figure 2 comprises a rigid board 11 of resin bonded glass fibre having extending through the board a multiplicity of holes 12, of which one only is shown, arranged in a pattern of rows and columns. Secured to one major surface of the rigid board 11 by means of double-sided self-adhesive tape 16 of polypropylene in which the adhesive is a non-setting adhesive, is a flexible sheet 14 of a polyimide, separately formed with respect to the rigid board, which sheet carries on its surface remote from the rigid board a pattern of strips and/or pads 18, of which one only is shown, each consisting of a coating of copper, the strips and/or pads overlying holes 12 in the rigid board.

Secured to the other major surface of the rigid board 11 by double-sided self-adhesive tape 16 of polypropylene of which the adhesive is a non-setting adhesive, is a laminate of three flexible sheets 14, each of a polyimide, adjacent sheets being secured together by intervening double-sided self-adhesive tape 16. Each flexible sheet 14 of the laminate 13 carries on the surface of the flexible sheet nearer the rigid board a pattern of electrically conductive strips and/or pads 18, each consisting of a coating of copper, which strips and/or pads overlie holes 12 in the rigid board 11.

When the second preferred form of circuit board is to be used and it is desired to effect electrical contact between strips and/or pads 18 of the flexible sheets 14 by means of a contact pin C, the pin is urged through the single flexible sheet 14 secured to one major surface of the rigid board 11, through the board and subsequently through the flexible sheets 14 constituting the laminate 13 secured to the other major surface of the rigid board in such a way that, in respect of each flexible sheet, the pin initially pierces the copper strip or pad before piercing the sheet itself.

It will be appreciated that, in each of the preferred forms of circuit board, the electrically conductive strips and/or pads on the or each flexible sheet may be readily formed in accordance with a standard or non-standard pattern using a computer aided design plotter (CAD).

## Claims

1. A circuit board comprising a substantially rigid board (1,11) of which at least the major surfaces are of electrically insulating material and which has extending through the rigid board a multiplicity of holes (2,12) arranged in a pattern of rows and columns and, secured to one major surface of the rigid board, a separately formed flexible sheet (4,14) of electrically insulating material which carries on the surface of the flexible sheet remote from the rigid board a pattern of electrically conductive strips and/or pads (8,18) which overlies holes in the rigid board, the strips and/or pads being of such an electrically conductive material and of such a thickness that, when a pin (C) is urged through an electrically conductive strip or pad and the underlying flexible sheet into an underlying hole in the rigid board, electrically conductive material pierced by the pin will effect an electrical contact with the pin passing therethrough.

2. A circuit board as claimed in Claim 1, wherein one major surface of the rigid board (11) has secured thereto a laminate of two or more sheets (14) of electrically insulating material, each of which flexible sheets - except the flexible sheet immediately adjacent and secured to the rigid board - is secured to the underlying flexible sheet and each of which flexible sheets carries on the surface of the flexible sheet remote from the rigid board a pattern of electrically conductive strips and/or pads (18) which overlies holes (12) in the rigid board.

3. A circuit board as claimed in Claim 1 or 2, wherein the other major surface of the rigid board (11) has secured thereto at least one separately formed flexible sheet (14) of electrically insulating material which carries on the surface of the flexible sheet nearer the rigid board a pattern of electrically conductive strips and/or pads (18) which overlies holes (12) in the rigid board.

4. A circuit board as claimed in any one of the preceding Claims, wherein the flexible sheet (4,14) is secured to said major surface of the rigid board (1,11) - and in a laminate of two or more flexible sheets the flexible sheet is secured to an underlying flexible sheet - by means of double-sided self-adhesive tape (6,16) of electrically insulating material in which the adhesive is a non-setting adhesive.

5. A circuit board as claimed in any one of the preceding Claims, wherein the or each flexible sheet (4,14) is made of electrically insulating plastics material having such inherent elasticity that, when an electrically conductive strip or pad (8,18) and the underlying flexible sheet are pierced by a pin (C), the inherent elasticity of the plastics material of the sheet tends to urge the electrically conductive material of the pierced strip or pad into electrical contact with the pin.

6. A kit of parts for use in the assembly of a circuit board as claimed in any one of the preceding Claims, which kit of parts comprises at least one substantially rigid board (1) of which at least the major surfaces are of electrically insulating material and which has extending through the rigid board a multiplicity of holes (2) arranged in a pattern of rows and columns; at least one separately formed flexible sheet (4) of electrically insulating material; and means (6) for securing a flexible sheet to a surface of the rigid board or to an underlying flexible sheet.

7. A kit of parts as claimed in Claim 6, wherein the means for securing a flexible sheet to a surface of the rigid board or to an underlying flexible sheet is double-sided self-adhesive tape (6) of electrically insulating material in which the adhesive is a non-setting adhesive.

8. A kit of parts as claimed in Claim 6 or 7, which kit of parts also includes any one or more of pin-insertion equipment, at least one punching pin, a block of cellular plastics material having a pair of opposed major surfaces lying in substantially parallel planes or at least one substantially rigid backing board having extending through the board a multiplicity of holes arranged in a pattern of rows and columns corresponding to the pattern of holes in the or each rigid board of the kit of parts, and a plurality of at least one kind of contact pin.

9. A kit of parts as claimed in any one of Claims 6 to 8, wherein the or each separately formed flexible sheet (4) of the kit of parts has a coating of copper or other metal or metal alloy of high electrical conductivity on one surface of the sheet, the coating being of such a thickness that, when a pattern of strips and/or pads has been formed from the coating on the sheet and the sheet is secured to a surface of the rigid board in such a way that the pattern of strips and/or pads overlies holes in the rigid board and a pin is urged through a strip or pad into an underlying hole in the rigid board, copper or other electrically conductive metal or metal alloy pierced by the pin will effect an electrical contact with the pin passing therethrough.

10. For use in the assembly of a circuit board as claimed in any one of Claims 1 to 5, a flexible sheet (4) of electrically insulating material which carries on one of its surfaces a pattern of electrically conductive strips and/or pads (8), which strips and/or pads are of such an electrically conductive material and are of such a thickness that, when the flexible sheet is secured to a surface of a substantially rigid board (1) of which at least the major surfaces are of electrically insulating material and which has extending through the rigid board a multiplicity of holes (2) arranged in a pattern of rows and columns in such a way that the pattern of electrically conductive strips and/or pads is remote from and overlies holes in the rigid board and a pin is urged through an electrically conductive strip or pad and the underlying flexible sheet into an underlying hole in the rigid board, electrically conductive material pierced by the pin will effect an electrical contact with the pin passing therethrough.

Fig.1.

Fig.2.